# EUROPÄISCHE PATENTSCHRIFT

(11) **EP 1 147 248 B1**
(45) Veröffentlichungstag und Bekanntmachung des Hinweises auf die Patenterteilung: **18.09.2002**
(21) Anmeldenummer: 00922527.7
(22) Anmeldetag: 16.03.2000
(51) Int. Cl.: C30B 11/00, C30B 29/42

(54) **VORRICHTUNG ZUR HERSTELLUNG VON EINKRISTALLEN**
DEVICE FOR PRODUCING SINGLE CRYSTALS
DISPOSITIF PERMETTANT DE PRODUIRE DES MONOCRISTAUX

(30) Priorität: 19.03.1999 DE 19912484
(43) Veröffentlichungstag der Anmeldung: 24.10.2001
(73) Patentinhaber: Freiberger Compound Materials GmbH, 09599 Freiberg (DE); Forschungszentrum Jülich GmbH, 52425 Jülich (DE)
(72) Erfinder: SONNENBERG, Klaus, D-52382 Niederzier (DE); KÜSSEL, Eckhard, D-52353 Düren (DE); BÜNGER, Thomas, D-09131 Chemnitz (DE); FLADE, Tilo, D-09599 Freiberg (DE); WEINERT, Berndt, D-09599 Freiberg (DE)
(74) Vertreter: Prüfer, Lutz H., Dipl.-Phys.
(86) Internationale Anmeldenummer: EP0002349
(87) Internationale Veröffentlichungsnummer: WO00056954

(56) Entgegenhaltungen:
- DE-A- 3 323 896
- US-A- 4 086 424
- ALTHAUS M ET AL: "SOME NEW DESIGN FEATURES FOR VERTICAL BRIDGMAN FURNACES AND THE INVESTIGATION OF SMALL ANGLE GRAIN BOUNDARIES DEVELOPED DURING VB GROWTH OF GAAS" JOURNAL OF CRYSTAL GROWTH,NL,NORTH-HOLLAND PUBLISHING CO. AMSTERDAM, Bd. 166, Nr. 1/04, 1. September 1996 (1996-09-01), Seiten 566-571, XP000686560 ISSN: 0022-0248
- PATENT ABSTRACTS OF JAPAN vol. 1998, no. 13, 30. November 1998 (1998-11-30) & JP 10 203891 A (HITACHI CABLE LTD), 4. August 1998 (1998-08-04)

## Beschreibung

Die Erfindung betrifft eine Vorrichtung zur Herstellung von Einkristallen. Insbesondere betrifft die Erfindung eine Vorrichtung zur Herstellung von Einkristallen verschiedener Materialien, beispielsweise III-V-Materialien, beispielsweise von Galliumarsenid-Einkristallen.

Bekannte Vorrichtungen zur Herstellung von Einkristallen unterschiedlicher Materialien, beispielsweise III-V-Materialien, beispielsweise von Galliumarsenid, bestehen im allgemeinen aus Vielzonenöfen, wie sie zum Beispiel in der DE-OS-38 39 97, sowie in den US-Patentschriften US 4,086,424, US 4,423,516 und US 4,518,351 beschrieben sind.

Diese Vielzonenöfen können sowohl aus metallischen Heizleitern, als auch aus kohlenstoffhaltigen Heizleitern bestehen. Die sogenannten Mehrzonenrohröfen gestatten einen variablen Aufbau eines zur Kristallzüchtung geeigneten Temperaturfeldes und dessen Verschiebung entlang der Rotationsachse des Ofens.

Derartige Vorrichtungen sind jedoch sowohl durch einen axialen als auch durch einen radialen Wärmefluß gekennzeichnet, was zu einer variablen Wachstumsgeschwindigkeit und einer ungünstigen Ausbildung der Phasengrenzfläche Schmelze-Kristall führen kann.

Desweiteren sind Mehr- bzw. Vielzonenöfen aus einer Vielzahl thermischer Bauelemente zusammengesetzt, was bei Wartungsarbeiten einen hohen Demontage- und Montageaufwand erfordert. Mit steigender Zonenzahl erhöht sich auch der Automatisierungsaufwand und die Störungsanfälligkeit der Mehrzonenöfen.

Insbesondere für die Herstellung von Einkristallen mit einem großen Durchmesser, beispielsweise 2", 3", 100 mm, 125 mm, 150 mm, 200 mm und größer, besteht das Problem, daß ein radialer Wärmefluß im Kristall eine Auswirkung auf die Isothermen, d.h. auf die Phasengrenze Schmelze-Einkristall in vertikaler bzw. axialer Richtung hat.

Aus dem Journal of Crystal Growth, NL, North-Holland Publishing Co. Amsterdam, Bd. 166, Nr. 1/04, 1. September 1996 Seiten 566-571, ist eine Vorrichtung nach dem Oberbegriff des Anspruchs 1 bekannt.

Aufgabe der Erfindung ist es, eine Vorrichtung zur Herstellung von Einkristallen, insbesondere von Einkristallen unterschiedlicher III-V-Materialien, beispielsweise von Galliumarsenid, bereitzustellen, bei der eine fast ausschließlich axiale Wärmeführung gewährleistet ist.

Die Aufgabe wird gelöst durch eine Vorrichtung nach Anspruch 1.

Weiterbildungen sind in den Unteransprüchen angegeben.

Die Vorrichtung hat den Vorteil, daß ein homogener axialer Wärmefluß gewährleistet ist und daß in radialer Richtung nahezu keine Wärme abfließen kann, d.h. einer radial homogenen Temperatur an der oberen und unteren Heizplatte und den dazwischenliegenden Schnitten.

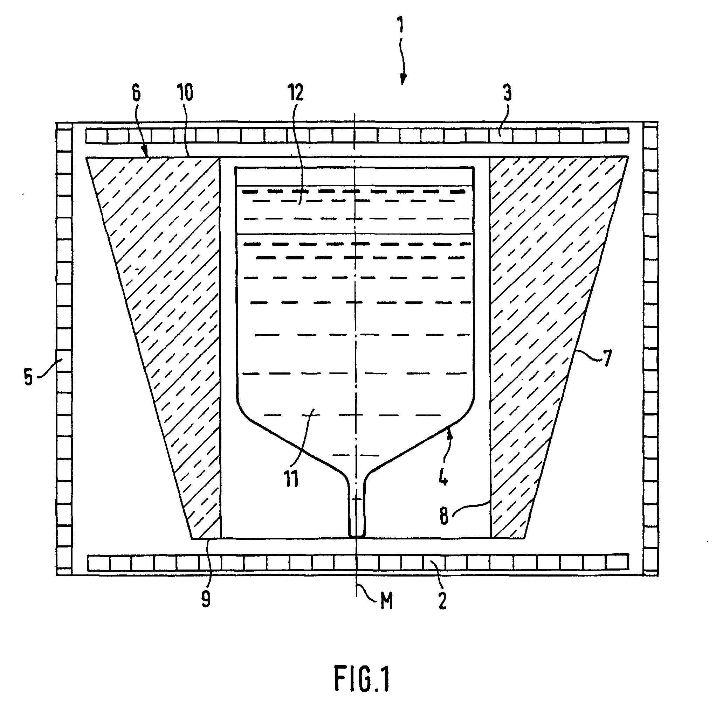

Weitere Merkmale und Zweckmäßigkeiten ergeben sich aus der Beschreibung eines Ausführungsbeispieles anhand der Figur 1.

Die Figur zeigt eine schematische Querschnittsansicht der erfindungsgemäßen Vorrichtung mit einer sich vertikal erstrekkenden Rotationsachse M.

Die Vorrichtung zur Herstellung von Einkristallen weist einen zylinderförmigen Ofen 1 mit einer unteren Heizplatte als Bodenheizer 2 und einer oberen Heizplatte als Deckelheizer 3 auf. Die hochwärmeleitfähigen Heizplatten (z.B. CFC) haben einen kreisförmigen Querschnitt. Der Durchmesser des Bodenheizers 2 und des Deckelheizers 3 beträgt wenigstens das 1,5- bis 2-fache des Durchmessers des herzustellenden Einkristalles, so daß keine radialen Wärmeflüsse im System auftreten, die unter anderen durch die nichtrotationssymetrischen Einflüsse der Stromzuführung verursacht sind. Der Abstand zwischen Bodenheizer 2 und Deckelheizer 3 ist so bemessen, daß ein Tiegel 4 für die Kristallzüchtung dazwischen angeordnet werden kann.

Es ist eine nicht dargestellte Steuer- und Regeleinrichtung vorgesehen, mit der der Bodenheizer 2 und der Deckelheizer 3 derart angesteuert werden können, daß der Deckelheizer 3 auf einer in etwa der Schmelztemperatur des zu verarbeitenden Rohmateriales gehalten werden kann und der Bodenheizer 2 auf einer geringeren Temperatur gehalten werden kann. Die Steuerung ist ferner so ausgebildet, daß die Temperatur des Bodenheizers 2 im Vergleich zur Temperatur des Deckelheizers während des Züchtungsprozesses kontinuierlich abgesenkt werden kann, damit die Schmelze von Rohmaterial in dem Tiegel 4 kontinuierlich von unten nach oben erstarren kann.

Der zylindrische Ofen 1 weist ferner eine Mantelheizung 5 auf, die beispielsweise in der zylindrischen Begrenzungswand des Ofens ausgebildet ist. Es ist eine Steuer- und Regeleinrichtung, vorgesehen, die derart ausgebildet ist, daß die Mantelheizung 5 auf einer Temperatur in der Nähe des Schmelzpunktes des in den Tiegel eingefüllten Rohmateriales gehalten werden kann.

Zum Verhindern eines Wärmeflusses in radialer Richtung weist der Ofen 1 ferner einen rotationssymmetrisch ausgebildeten Isolator 6 aus wärmeisolierendem Material, auf. Der Isolator 6 ist als ein kegelstumpfförmiger Körper ausgebildet mit einem koaxialen, oben und unten offenen zylindrischen Innenraum. Die Außenwand 7 des Isolators 6 hat somit die Form eines Kegelstumpfes und die Innenwand 8 die eines Zylinders. Der Isolator 6 ist in dem Ofen so angeordnet, daß sein jüngeres Ende 8 dem Bodenheizer 2 und das dem jüngeren Ende gegenüberliegende Ende dem Deckelheizer 3 zugewandt ist. Der Innendurchmesser des Isolators ist größer, als der Durchmesser des einzusetzenden Tiegels 4. Der Isolator ist bevorzugt aus Graphit gebildet. Durch die hohlkegelstumpfförmige Ausbildung des Wärmeübertragungsprofiles 6 ergibt sich ein freier Strahlungsraum 9 zwischen dem Wärmeübertragungsprofil und dem Mantelheizer 5, der zum azimutalen Ausgleich der Temperatur über den Hauptheizer beiträgt.

Durch die oben beschriebene Ausbildung und Anordnung des Isolators 6 in dem Ofen 1 wird eine von dem Deckelheizer 3 zu dem Bodenheizer 2 abnehmende Wärmeisolation in radialer Richtung zwischen einer in dem Tiegel 4 vorhandenen Schmelze von Rohmaterial und der Mantelheizung 5 bewirkt.

Im Betrieb wird zunächst der Tiegel 4, der den Kristallkeim enthält, in den Ofen eingesetzt. Dann wird Boroxid B₂O₃ und polykristallines Galliumarsenid zugegeben. Dann wird der Mantelheizer 5 derart angesteuert, daß er auf eine Temperatur gebracht wird, die ausreicht, um den Reaktionsraum bis auf die Arbeitstemperatur zu erhitzen und das feste Vorlaufmaterial aufzuschmelzen. Das eingefüllte polykristalline Galliumarsenid wird aufgeschmolzen, so daß es eine Galliumarsenidschmelze 10 bildet und von einer Abdeckschmelze 11 aus geschmolzenem B₂O₃ abgedeckt, damit eine Berührung des Galliumarsenids mit der Tiegelinnenwand vermieden wird.

Der Züchtungsprozeß wird dann wie folgt durchgeführt. Der Dekkelheizer 3 wird auf eine Temperatur von ca. 1300°C gebracht und der Bodenheizer 2 wird auf eine Temperatur von ca. 1200°C gebracht. Zwischen Deckelheizer 3 und Bodenheizer 2 bildet sich ein Temperaturgradient, der nahezu dem Temperaturgradienten, der zwischen zwei unendlich ausgebildeten parallelen ebenen Platten gegeben ist, aus. Dann wird die Temperatur des Bodenheizers kontinuierlich abgesenkt, so daß die Schmelze 11 in dem Tiegel 4 gleichmäßig von unten nach oben auskristallisiert. Durch Steuerung und/oder Regelung der Temperatur des Bodenheizers 2 relativ zu der Temperatur des Deckelheizers 3 ist es somit möglich, die Schmelzisotherme in ihrer vertikalen Position zwischen den beiden Heizern zu verschieben und daher die Kristallisation zu steuern. Der Mantelheizer muß über die Prozeßzeit geringfügig nachgeführt werden, um den idealen axialen Temperaturfluß aufrecht zu erhalten, da der Gesamtenergiehaushalt des Systems abgesenkt wird und damit die radialen Verluste, die über den Mantelheizer kompensiert werden, abnehmen.

Der Mantelheizer 5 dient zum Ausgleich von globalen Wärmeverlusten und zur Unterbindung eines radialen Wärmeflusses. Durch den Isolator 6 wird im Bereich des Deckelheizers 3 eine hohe Isolation in radialer Richtung und im Bereich des Bodenheizers 2 eine geringere Isolation in radialer Richtung erreicht. Dadurch wird ein axialer Wärmefluß parallel zu Rotationsachse des Ofens während des Kristallisationsprozesses gewährleistet.

Während des Kristallisationsprozesses und danach ist so die Isothermenausbildung im Reaktionsgefäß in jeder Form möglich. Die angestrebte Isothermenform kann durch den streng axialen Wärmefluß über die gesamte Höhe des Reaktionsraumes zwischen dem Deckelheizer 3 und dem Bodenheizer 2 verschoben werden.

Die erfindungsgemäße Vorrichtung ermöglicht die Herstellung von Einkristallen unterschiedlicher III-V-Materialien mit großen Durchmessern, wie beispielsweise Galliumarsenid mit einem Durchmesser von 2", 3", 100 mm, 125 mm, 150 mm, 200 mm und größer.

In Abhängigkeit von dem herzustellenden Einkristall, beispielsweise hinsichtlich seines Materials oder seines Durchmessers kann der Isolator 6 auch als Hohlzylinder ausgebildet sein. Ziel ist es lediglich einen streng axialen Wärmefluß zu gewährleisten und ein Abfließen der Wärme in radialer Richtung zu verhindern. Damit kann das Ziel erreicht werden, pro Zeiteinheit einen konstanten Kristallisationszuwachs zu erhalten.

In einer abgewandelten Form ist der Wärmeübertragungszylinder 6 nicht hohlkegelstumpfförmig ausgebildet, sondern ist so ausgebildet, daß ein gewünschter axialer Isothermenverlauf erreicht wird. Eine beliebige Form ist dabei denkbar und wird anhand des gewünschten Isothermeverlaufes berechnet. Durch die Form des Materials und die Art des Materials lassen sich beliebige gewünschte Wärmeflüsse modellieren. Damit kann das Ziel erreicht werden, pro Zeiteinheit einen konstanten Kristallisationszuwachs zu erhalten.

## Patentansprüche

1. Vorrichtung zur Herstellung eines Einkristalls durch Züchtung aus einer Schmelze von Rohmaterial des herzustellenden Einkristalls,
mit einer Heizeinrichtung (1) zum Erzeugen eines Temperaturgradienten innerhalb der Schmelze aus Rohmaterial, wobei die Heizeinrichtung (1) einen rotationssymmetrischen Ofen (1) mit einer Rotationsachse (M) und mit einem im wesentlichen ebenen Bodenheizer (2) einem im wesentlichen ebenen Deckelheizer (3) aufweist, die auf unterschiedliche Temperaturen steuerbar sind, **dadurch gekennzeichnet, daß** eine Isolatoreinrichtung vorgesehen ist, die derart ausgebildet ist, daß ein Wärmefluß in einer radialen Richtung senkrecht zur Rotationsachse (M) des Ofens (1) auf ein vorbestimmtes Maß begrenzbar ist, und wobei
die Isolatoreinrichtung (6) ausgebildet ist, daß sie eine von dem Deckelheizer (3) zu dem Bodenheizer (2) abnehmende Isolationswirkung aufweist.

2. Vorrichtung nach Anspruch 1, **dadurch gekennzeichnet, daß** der Ofen zylindrisch ausgebildet ist und daß eine Steuereinrichtung vorgesehen ist, die so ausgebildet ist, daß die Temperatur des Bodenheizers (2) im Vergleich zur Temperatur des Deckelheizers (3) absenkbar ist.

3. Vorrichtung nach Anspruch 1 oder 2, **dadurch gekennzeichnet, daß** die Isolatoreinrichtung (6) als kegelstumpfförmiger Körper mit einem koaxialen zylindrischen und oben und unten offenen Hohlraum ausgebildet ist, der so in dem Ofen (1) angeordnet ist, daß sein jüngeres Ende den Bodenheizer (2) zugewandt ist.

4. Vorrichtung nach einem der Ansprüche 1 bis 3, **dadurch gekennzeichnet, daß** der Ofen (1) eine Mantelheizung (5) aufweist.

5. Vorrichtung nach einem der Ansprüche 1 bis 4, **dadurch gekennzeichnet, daß** das Wärmeübertragungsteil (6) eine rotationssymmetrische profilierte bzw. unprofilierte Form besitzt.

6. Vorrichtung nach einem der Ansprüche 1 bis 5, **dadurch gekennzeichnet, daß** eine Heizfläche der Heizer im Verhältnis zu dem Durchmesser des herzustellenden Einkristalls so bemessen ist, daß ein über die radiale Querschnittsfläche des herzustellenden Einkristalls im wesentlichen homogene Temperatur und zwischen dem ersten Heizer (2) und dem zweiten Heizer (3) im wesentlichen ein homogener konstanter Temperaturgradient erzeugbar ist.

7. Vorrichtung nach Anspruch 6, **dadurch gekennzeichnet, daß** die Größe der Fläche jedes Heizers (2,3) wenigstens das 1,5-fache der Querschnittsfläche des herzustellenden Einkristalls beträgt.

8. Vorrichtung nach einem der Ansprüche 2 bis 7, **dadurch gekennzeichnet, daß** die Steuerung so ausgebildet ist, daß die Temperatur des ersten ebenen Heizers (2) gegenüber dem zweiten ebenen Heizer (3) kontinuierlich absenkbar ist.

9. Vorrichtung nach einem der Ansprüche 1 bis 8, **dadurch gekennzeichnet, daß** der Abstand der Heizer zueinander größer als die Länge des herzustellenden Einkristalls ist.

10. Vorrichtung nach einem der Ansprüche 1 bis 9, **dadurch gekennzeichnet, daß** die Isolatoreinrichtung z.B. aus Graphit gebildet ist.

11. Vorrichtung nach einem der Ansprüche 1 bis 10, **dadurch gekennzeichnet, daß** ein Tiegel (4) zur Aufnahme einer Schmelze an Rohmaterial des herzustellenden Einkristalls vorgesehen ist, der zwischen dem ersten Heizer (2) und dem zweiten Heizer (3) angeordnet ist.

12. Vorrichtung nach einem der Ansprüche 1 bis 11, **dadurch gekennzeichnet, daß** die Vorrichtung eine Vorrichtung zur Herstellung eines Einkristalls aus einem III-V-Verbundhalbleiter ist.

13. Vorrichtung nach einem der Ansprüche 1 bis 12, **dadurch gekennzeichnet, daß** die Vorrichtung eine Vorrichtung zum Herstellen eines Einkristalls aus Galliumarsenid ist.

## Claims

1. Device for producing a monocrystal by growing from a melt of raw material of the monocrystal to be produced with a heating appliance (1) for generating a temperature gradient within the melt of raw material whereby the heating appliance (1) has a rotationally symmetrical furnace (1) with a rotation axis (M)and with an essentially level floor heater (2) and an essentially level cover heater (3) that can be controlled to different temperatures and **characterized by** an insulating device being planned that is designed in such a way that that a heat flow in a radial direction vertical to the rotation axis (M) of the furnace (1) can be restricted to a preset rate and whereby the insulating device (6) is designed so that its insulating effect is reduced from the cover heater (3) to the floor heater (2) .

2. Device in accordance with Claim 1 **characterized by** the furnace being designed cylindrically and by there being a controller that is designed in such a way that the temperature of the floor heater (2) can be reduced in comparison with the temperature of the cover heater.

3. Device in accordance with Claims 1 or 2 **characterized by** an insulator device (6) that is designed as a tapered cone body with a coaxial cylindrical hollow space that is open at the top and bottom and placed in the furnace (1) in such a way that the tapered end is towards the floor heater (2).

4. Device in accordance with one of the Claims 1 to 3 **characterized by** the furnace (1) having a jacket heater (5).

5. Device in accordance with one of the Claims 1 to 4 **characterized by** the heat transmission part (6) having a rotationally symmetrical profiled or unprofiled shape.

6. Device in accordance with one of the Claims 1 to 5 **characterized by** a heating surface of the heaters being calculated in a ratio to the diameter of the monocrystal to be produced so that a temperature that is essentially homogeneous over the radial cross-section surface of the monocrystal to be produced can be generated together with a temperature gradient between the first heater (2) and the second heater (3) that is essentially homogeneous and constant.

7. A device in accordance with Claim 6 **characterized by** the size of the surface of each heater (2, 3) being at least 1.5 times the cross-sectional area of the monocrystal to be produced is calculated.

8. A device in accordance with one of the Claims 2 to 7 **characterized by** the controller being designed so that the temperature of the first level heater (2) can be lowered continuously as against the second level heater (3).

9. A device in accordance with one of the Claims 1 to 8 **characterized by** the clearance between the heaters being greater than the length of the monocrystal to be produced.

10. A device in accordance with Claims 1 to 9 **characterized by** the insulator device being made, for example, of graphite.

11. A device in accordance with one of the Claims 1 to 10 **characterized by** a crucible (4) for receiving a melt of raw material of the monocrystal to be produced being provided that is located between the first heater (2) and the second heater (3).

12. A device in accordance with one of the Claims 1 to 11 **characterized by** the device being a device for producing a monocrystal from a III-V composite semiconductor.

13. A device in accordance with one of the Claims 1 to 12 **characterized by** the device being a device for producing a monocrystal from gallium arsenide.

## Revendications

1. Dispositif pour la production de monocristaux par tirage à partir d'une masse fondue de matériau pour le monocristal à produire, comprenant un dispositif de chauffage (1) destiné à produire un gradient de température dans la masse fondue de matériau, lequel dispositif de chauffage (1) comprend un four (1) symétrique sur l'axe de rotation avec un axe de rotation (M) et un élément chauffant de fond (2) sensiblement plan et un élément chauffant de couvercle (3) sensiblement plan, dont la température peut être réglée différemment, **caractérisé en ce qu'**il est prévu un dispositif isolant conçu de telle sorte que la circulation de chaleur dans un sens radial perpendiculaire à l'axe de rotation (M) du four (1) puisse être limitée à une valeur pouvant être prédéterminée, et dans lequel le dispositif isolant (6) est conformé de telle sorte que son effet isolant diminue entre l'élément chauffant de couvercle (3) et l'élément chauffant de fond (2).

2. Dispositif selon la revendication 1, **caractérisé en ce que** le four est de forme cylindrique et **en ce qu'**il est prévu un dispositif de régulation conçu de telle sorte que la température de l'élément chauffant de fond (2) puisse être abaissée par rapport à la température de l'élément chauffant de couvercle (3).

3. Dispositif selon la revendication 1 ou 2, **caractérisé en ce que** le dispositif isolant (6) est conformé comme un corps tronconique avec une cavité cylindrique coaxiale et ouverte vers le haut et le bas, qui est disposé dans le four (1) de telle manière que son extrémité la plus étroite est orientée vers l'élément chauffant de fond (2).

4. Dispositif selon l'une ou l'ensemble des revendications 1 à 3, **caractérisé en ce que** le four (1) présente une enveloppe chauffante (5).

5. Dispositif selon l'une ou l'ensemble des revendications 1 à 4, **caractérisé en ce que** la partie assurant le transfert thermique (6) présente une forme profilée ou non profilée symétrique sur l'axe de rotation.

6. Dispositif selon l'une ou l'ensemble des revendications 1 à 5, **caractérisé en ce qu'**une surface chauffante des éléments chauffants est dimensionnée par rapport au diamètre du monocristal à produire de manière à pouvoir obtenir une température sensiblement homogène sur l'aire de section radiale du monocristal à produire et un gradient de température sensiblement constant et homogène entre le premier élément chauffant (2) et le second élément chauffant (3).

7. Dispositif selon la revendication 6, **caractérisé en ce que** la taille de la surface de chaque élément chauffant (2, 3) correspond à au moins 1,5 fois l'aire de section du monocristal à produire.

8. Dispositif selon l'une ou l'ensemble des revendications 2 à 7, **caractérisé en ce que** la commande est conçue de telle sorte que la température du premier élément chauffant plan (2) puisse être abaissée de façon continue par rapport au second élément chauffant plan (3).

9. Dispositif selon l'une ou l'ensemble des revendications 1 à 8, **caractérisé en ce que** la distance entre les éléments chauffants est supérieure à la longueur du monocristal à produire.

10. Dispositif selon l'une ou l'ensemble des revendications 1 à 9, **caractérisé en ce que** le dispositif d'isolation est composé, par exemple, de graphite.

11. Dispositif selon l'une ou l'ensemble des revendications 1 à 10, **caractérisé en ce qu'**il est prévu pour recevoir une masse fondue de matériau pour le monocristal à produire un creuset (4) disposé entre le premier élément chauffant (2) et le second élément chauffant (3).

12. Dispositif selon l'une ou l'ensemble des revendications 1 à 11, **caractérisé en ce que** le dispositif est un dispositif pour la production d'un monocristal composé d'un semi-conducteur composite III-V.

13. Dispositif selon l'une ou l'ensemble des revendications 1 à 12, **caractérisé en ce que** le dispositif est un dispositif pour la production d'un monocristal d'arséniure de gallium.
